(19) Europäisches Patentamt / European Patent Office / Office européen des brevets

(11) **EP 4 678 598 A1**

(12) **EUROPEAN PATENT APPLICATION**
published in accordance with Art. 153(4) EPC

(43) Date of publication:
**14.01.2026 Bulletin 2026/03**

(21) Application number: **24767007.8**

(22) Date of filing: **29.02.2024**

(51) International Patent Classification (IPC):
**C01B 33/00** (2006.01)  **C23C 26/00** (2006.01)
**H01L 23/13** (2006.01)

(52) Cooperative Patent Classification (CPC):
**C01B 33/00; C23C 26/00; H01L 23/13**

(86) International application number:
**PCT/JP2024/007502**

(87) International publication number:
**WO 2024/185637 (12.09.2024 Gazette 2024/37)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **03.03.2023 JP 2023032537**

(71) Applicant: **NOF Corporation**
**Tokyo 150-6012 (JP)**

(72) Inventors:
• IIZUKA,Muneaki
 Tsukuba-shi, Ibaraki 300-2635 (JP)
• FUJIMURA,Toshinobu
 Tsukuba-shi, Ibaraki 300-2635 (JP)
• NAKASATO,Katsumi
 Tsukuba-shi, Ibaraki 300-2635 (JP)
• SATO,Kyohei
 Tsukuba-shi, Ibaraki 300-2635 (JP)
• HIRATA,Junya
 Tsukuba-shi, Ibaraki 300-2635 (JP)

(74) Representative: **Hoffmann Eitle**
**Patent- und Rechtsanwälte PartmbB**
**Arabellastraße 30**
**81925 München (DE)**

(54) **METAL OXIDE FILM, METAL OXIDE LAMINATE, AND METHOD FOR PRODUCING METAL OXIDE LAMINATE**

(57) Provided is an amorphous metal oxide film, wherein the metal oxide film is represented by composition formula: SiaAlbOcTd (in the formula, Si is a silicon atom; Al is an aluminum atom; O is an oxygen atom; T is at least one atom other than Si, Al, and O; a, b, c, and d represent weight ratios; a + b + c + d=100; a is 3-45; b is 5-50; c is 35-60; and d is 0.05-10), and has a thickness of 0.1-30 μm. The metal oxide film can provide a metal oxide multilayer having excellent adhesion, heat dissipation, insulation, and high-voltage resistance.

FIG. 1

EP 4 678 598 A1

**Description**

TECHNICAL FIELD

The present invention relates to a metal oxide film, a metal oxide multilayer, and a method for producing a metal oxide multilayer.

BACKGROUND ART

Conventionally, metallic heat dissipation members have been used to release heat generated by electronic parts such as semiconductor chips and antennas to the outside of the system. Among these heat dissipation members, there is a heat dissipation circuit board that is provided with an insulating layer so as not to conduct electricity. However, with the increase in power as typified by electric vehicles in recent years, heat dissipation members are increasingly being used at high temperatures. For this reason, alumina and the like that are excellent in heat resistance, strength, and insulation properties are used as insulating materials.

Patent Document 1 proposes a substrate (CBC substrate: ceramic bonding cupper) in which a zirconia-reinforced alumina (ZTA) plate as an insulating multilayer is directly bonded to a foil-like copper plate.

Non-Patent Document 1 proposes a method for forming an insulating film of alumina on a silicon wafer. Non-Patent Document 2 describes an aluminosilicate film that exhibits higher insulation properties than alumina as alumina is doped with silicon.

PRIOR ART DOCUMENTS

PATENT DOCUMENT

Patent Document 1: JP-A-1996-195450
Non-Patent Document 1: Journal of the Society of Materials Science, Japan 2013 Vol. 62, No. 11, pp. 663-667
Non-Patent Document 2: Journal of Electric Engineering C 2007, Vol. 127, No. 11, pp. 1822-1825

SUMMARY OF THE INVENTION

PROBLEMS TO BE SOLVED BY THE INVENTION

However, the substrate described in Patent Document 1 is produced by a hot pressing method and thus cannot be formed into a thin film, the insulating layer is required to be 150 $\mu$m or more, and there is a problem such as insufficient heat dissipation properties. Furthermore, since the thermal expansion properties of metal materials are significantly different from those of ceramic, the ceramic cannot fully absorb the internal stress by temperature changes, and there are problems such as the occurrence of cracking of the ceramic and peeling off of the ceramic. The alumina film obtained by the method described in Non-Patent Document 1 has room for improvement from the viewpoint of voltage resistance. In a case where the aluminosilicate film described in Non-Patent Document 2 is formed on a substrate having a high coefficient of thermal expansion, the ceramic cannot fully absorb the internal stress by temperature changes, and there are problems such as cracking and peeling off of the ceramic.

The present invention has been made in view of such circumstances, and an object thereof is to provide a metal oxide film that affords a metal oxide multilayer excellent in adhesive properties, heat dissipation properties, insulation properties, and high voltage resistance, and another object thereof is to provide the metal oxide multilayer and a method for producing a metal oxide multilayer.

MEANS FOR SOLVING THE PROBLEMS

In other words, the present invention relates to an amorphous metal oxide film, in which the metal oxide film is represented by a composition formula: SiaAlbOcTd (in the formula, Si denotes a silicon atom; Al denotes an aluminum atom; O denotes an oxygen atom; T denotes one atom or a plurality of atoms other than Si, Al, and O; a, b, c, and d denote a weight ratio; a + b + c + d = 100, where a is 3 or more and 45 or less, b is 5 or more and 50 or less, c is 35 or more and 60 or less, and d is 0.05 or more and 10 or less), and has a thickness of 0.1 $\mu$m or more and 30 $\mu$m or less.

The present invention relates to a metal oxide multilayer in which the metal oxide film is directly layered on a sheet-like metal material having a thickness of 0.2 mm or more and 20 mm or less.

As a preferred aspect of the metal oxide multilayer of the present invention, the metal material is preferably copper or a copper alloy or aluminum or an aluminum alloy.

The present invention also relates to a method for producing the metal oxide multilayer, which includes a step of conveying mist or droplets obtained by atomizing or converting a coating liquid containing a silicon compound and an aluminum salt or complex with a carrier gas; and a step of reacting the mist or droplets on a metal material in a temperature atmosphere of 150°C or more and 450°C or less to obtain a metal oxide film.

EFFECT OF THE INVENTION

The metal oxide film of the present invention is a metal oxide film that is as extremely thin as 0.1 $\mu$m or more and 30 $\mu$m or less and exhibits high insulation properties, and thus affords a metal oxide multilayer that can exhibit both high heat dissipation properties and insulation properties. Furthermore, since this metal oxide film is amorphous and contains aluminum and silicon in mixture at an appropriate ratio, and thus affords a metal oxide multilayer that is excellent in adhesive properties, heat dissipation properties, insulation properties, and high voltage resistance and does not undergo cracking after a thermal cycle test as well.

BRIEF DESCRIPTION OF THE DRAWINGS

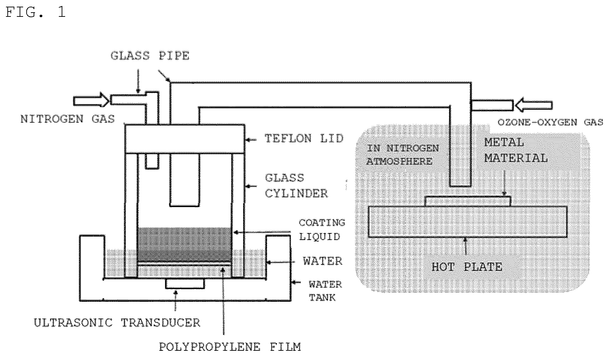

Fig. 1 is a schematic diagram of a film forming apparatus for a metal oxide film according to an embodiment of the present invention.

MODE FOR CARRYING OUT THE INVENTION

<Metal oxide film>

The metal oxide film of the present invention is amorphous, is represented by a composition formula: SiaAlbOcTd (in the formula, Si denotes a silicon atom; Al denotes an aluminum atom; O denotes an oxygen atom; T denotes one atom or a plurality of atoms other than Si, Al, and O; a, b, c, and d denote a weight ratio; a + b + c + d = 100, where a is 3 or more and 45 or less, b is 5 or more and 50 or less, c is 35 or more and 60 or less, and d is 0.05 or more and 10 or less), and has a thickness of 0.1 $\mu$m or more and 30 $\mu$m or less.

In the composition formula, a is preferably 5 or more, more preferably 10 or more from the viewpoint of high voltage resistance, and a is preferably 40 or less, more preferably 33 or less from the viewpoint of adhesive properties. b is preferably 8 or more, more preferably 10 or more from the viewpoint of adhesive properties, and b is preferably 40 or less, more preferably 37 or less from the viewpoint of high voltage resistance. From the viewpoint of high voltage resistance, c is preferably 40 or more, more preferably 44 or more, and is preferably 55 or less, more preferably 52 or less. d is preferably 0.1 or more, more preferably 0.2 or more from the viewpoint of preventing the metal oxide film from hardening and making the metal oxide film layer less likely to crack when distortion occurs due to heating, and d is preferably 8 or less, more preferably 5 or less from the viewpoint of enhancing the insulation properties. In other words, preferably, a is 5 or more and 40 or less, b is 8 or more and 40 or less, c is 40 or more and 55 or less, and d is 0.1 or more and 8 or less, and more preferably, a is 10 or more and 33 or less, b is 10 or more and 37 or less, c is 44 or more and 52 or less, and d is 0.2 or more and 5 or less. The composition ratio can be determined by dynamic SIMS.

In the composition formula, d preferably contains a carbon atom from the viewpoint of preventing the metal oxide film from hardening, enhancing adhesive properties and flexibility during a thermal cycle test, and preventing cracking.

The metal oxide film has a thickness of 0.1 $\mu$m or more and 30 $\mu$m or less, preferably 0.8 $\mu$m or more and 20 $\mu$m or less. When the thickness is 0.1 $\mu$m or more and 30 $\mu$m or less, the insulation properties, high voltage resistance, and heat dissipation properties are favorable, and the metal oxide film less likely to undergo cracking in a case of heating the metal oxide film to 100°C or more as well. As the metal oxide film is amorphous, flexibility is imparted to the metal oxide film, and therefore, the metal oxide film is excellent in adhesive properties at high temperatures and is less likely to undergo cracking during a thermal cycle test.

<Metal oxide multilayer>

In the metal oxide multilayer of the present invention, the metal oxide film is directly layered on a sheet-like metal material having a thickness of 0.2 mm or more and 20 mm or less. Direct layering in the present invention means that a layer of 100 nm or more is not interposed between the metal oxide film and the metal material.

From the viewpoint of heat dissipation properties, the metal material is preferably a material having a high thermal conductivity, and among these, the metal material is more preferably copper or a copper alloy or aluminum or an aluminum alloy. Furthermore, in a case where the metal material contains copper atoms or aluminum atoms, as the aluminum atoms or silicon atoms in the metal oxide film bond to the aluminum atoms or copper atoms in the metal material directly or via oxygen atoms at the interface between the metal material and the metal oxide film, the metal material and the metal oxide film can exhibit high adhesive properties to each other and higher thermal cycling resistance can be obtained.

As the copper or copper alloy or aluminum or aluminum alloy, known one can be adopted. Examples of the copper or copper alloy include a compound represented by the composition formula: CuxMyTz (Cu denotes a copper atom, M denotes a chromium, beryllium, molybdenum, nitrogen, or phosphorus atom, and T denotes one atom or a plurality of atoms other than Cu and M. x, y, and z denote a weight ratio, x + y + z = 100, x is preferably 60 or more and 100 or less, y is preferably 0 or more and 40 or less, and z is preferably 0 or more and 5 or less). Here, it is more preferable as the number of copper atoms in the metal material is larger, and x is more preferably 80 or more and 100 or less in a case where high adhesive properties are required.

Examples of the aluminum or aluminum alloy include a compound represented by the composition formula: AlxMyTz (Al denotes an aluminum atom, M denotes a copper or magnesium atom, and T denotes one atom or a plurality of atoms other than Al and M. x, y, and z denote a weight ratio, x + y + z = 100, x is preferably 80 or more and 100 or less, y is preferably 0 or more and 20 or less, and z is preferably 0 or more and 3 or less). Here, it is more preferable as the number of aluminum atoms in the metal material is larger, and x is more preferably 90 or more and 100 or less in a case where high adhesive properties are required.

The compounds represented by the respective composition formulas have a high thermal conductivity and are more suitable as heat dissipation members.

The metal material has a sheet shape with a thickness of 0.2 mm or more and 20 mm or less, preferably 0.5 mm or more and 20 mm or less. The heat dissipation performance is not sufficient in a case where the thickness of the metal material is thinner than 0.2 mm, and there is a disadvantage in the mounting process in a case of using the metal oxide multilayer as a heat dissipation circuit board when the thickness is thicker than 20 mm.

<Method for producing metal oxide multilayer>

In the metal oxide multilayer, the method for forming the metal oxide film is not particularly limited, and examples thereof preferably include physical vapor deposition methods such as vacuum deposition, ion plating, and sputtering, chemical vapor deposition methods such as plasma CVD, atomic layer deposition (ALD), organometallic CVD, and mist CVD, and coating methods in which a coating liquid is reacted on a metal material, such as spraying, ink jetting, spin coating, and dip coating. Among these, chemical vapor deposition methods and coating methods are preferable since the methods are excellent in the film formation speed and the film thickness uniformity in film formation.

In the chemical vapor deposition methods and coating methods, it is preferable that a metal oxide film is formed by heating and reacting a coating liquid containing an aluminum salt or complex and a silicon compound on a metal material in a temperature atmosphere of 150°C or more and 450°C or less since the metal atoms in the metal material bond to the aluminum atoms or silicon atoms in the metal oxide film directly or via oxygen bonds, and adhesive properties at the interface are enhanced. When the temperature for film formation exceeds 450°C, the thermal load on the metal material is large and the dimensional stability of the obtained multilayer deteriorate as well as the difference in coefficient of thermal expansion between the metal material and the metal oxide film is large, and cracks may be generated and warpage may occur in the metal oxide film when the temperature is returned to room temperature after film formation. When using a substrate particularly having a high coefficient of thermal expansion, such as copper or a copper alloy or aluminum or an aluminum alloy, as the metal material, the temperature for film formation is preferably 370°C or less, more preferably 350°C or less in order to prevent warpage due to the difference in coefficient of thermal expansion between the metal material and the metal oxide.

In particular, a method (abbreviated as mCVD) is most preferable in which when a coating liquid is heated and reacted on a metal material, a film is formed by a step of conveying mist or droplets obtained by atomizing or misting the coating liquid onto the metal material with a carrier gas such as nitrogen and by heating and reacting the mist or droplets on the metal material adjusted to a temperature of 150°C or more and 450°C or less. This method is a kind of chemical vapor deposition method. In this way, by forming a coating liquid containing an aluminum salt or complex and a silicon compound into minute droplets and reacting the minute droplets, a metal oxide is obtained which has a thin film thickness, is amorphous, and contains Si and Al that are uniformly dispersed therein. According to this method, since the reactivity of the aluminum salt or complex and the silicon compound in the coating liquid is increased by atomization or misting, a metal oxide can be obtained at a temperature of 150°C or more and 450°C or less, and a film can be formed without deteriorating the metal material. By forming a film by mCVD in a temperature region of 150°C or more and 450°C or less, it is possible to control the content of carbon atoms in the metal oxide in the range of 0.1% by weight to 5% by weight. For mCVD and its apparatus, for example, JP-A-2018-140352 and JP-A-2018-172793 can be used as reference.

The coating liquid preferably contains a combination of 0.2% by weight or more and 20% by weight or less of an aluminum complex or salt and 0.2% by weight or more and 20% by weight or less of a silicon compound or a compound containing silicon and aluminum elements in one molecule at 0.2% by weight or more and 20% by weight or less. The time for film formation increases when the contents of the aluminum complex or salt and the silicon compound are less than 0.2% by weight, and the carbon content increases and this causes a decrease in insulation properties when the content exceeds 20% by weight. The silicon compound may be any compound that can be atomized or misted, and examples thereof include silane, siloxane, silazane, polysilazane, and alkoxysilane.

In the mCVD, an oxidizing agent such as ozone, oxygen, and hydrogen peroxide may be used as the oxygen source, but ozone is more preferable. In order to prevent the atomized coating liquid from catching fire, water, alcohol, and the like may be used as an oxygen source. Here, the oxidizing source is a supply source of oxygen atoms for converting an aluminum complex or salt and a silicon compound into a metal oxide.

In this way, by forming a coating liquid containing an aluminum complex or salt and a silicon compound into minute mist or droplets and then reacting the minute mist or droplets on a metal material, it is also possible to fill concaves and convexes on the surface of the metal material.

The metal oxide multilayer can be used as a heat dissipation circuit board as the metal material is directly layered on one surface of the metal oxide film and a conductive metal multilayer is provided on the other surface of the metal oxide film. Such a heat dissipation circuit board can be utilized as a heat dissipation member.

EXAMPLES

Hereinafter, the present invention will be described with reference to Examples and the like, but the present invention is not limited to these.

<Production Example>

<Preparation of coating liquid>

<Example 1>

<Formation of metal oxide film>

Using the film forming apparatus (mCVD apparatus) illustrated in Fig. 1, a metal oxide film was formed on a metal material by the following method. A polyethylene film was fixed at a position 1 cm from the bottom of a glass cylinder (13 cm in diameter and 15 cm in height) with an O-ring and a caulking agent. A Teflon (registered trademark) lid was provided on the top of the cylinder, two holes were made in the attachment, and glass pipes with branch pipes for supplying nitrogen gas and for conveying mist were inserted into the holes. The glass pipe with a branch pipe for conveying mist was placed 1 to 2 cm away from the metal material on the hot plate, and the branch pipe was connected to an ozone generator via a Teflon tube so that ozone-oxygen gas could be introduced. The cylinder was immersed in a water bath, and an ultrasonic transducer (Ultrasonic Atomizer Unit HMC-2401; manufactured by HONDA ELECTRONICS CO., LTD.) was installed directly below the polypropylene. The hot plate was placed in a box filled with nitrogen, and film formation was started when the oxygen concentration reached 1% or less. The coating liquid was put into the cylinder, the ultrasonic transducer was activated, ultrasonic waves were transmitted to the coating liquid via the water in a water tank and the polypropylene, and a portion of the coating liquid was atomized. The atomized coating liquid was transported onto the metal material (30 mm $\times$ 30 mm) by nitrogen gas. It was examined whether the metal material was heated by the hot plate and the atomized coating liquid reached the metal material, supply of ozone was started and the chemical reaction was conducted to form a metal oxide layer, whereby a multilayer was obtained. The film thickness of the metal oxide layer was adjusted by the time for film formation (the time during which the atomized coating liquid was sprayed onto the metal material) and measured by the following method. The nitrogen gas flow rate was set to 11 L/min, the ozone concentration in the ozone-oxygen gas was set to 5000 ppm, the ozone-oxygen gas flow rate was set to 1 L/min, the vibration frequency of the ultrasonic transducer was set to 2.4 MHz, the voltage was set to 24 V, and the current was set to 0.6 A. Table 1 presents the conditions such as the used metal materials, coating liquids, and hot plate temperatures.

<Measurement of thickness of metal oxide film>

The measurement of the thickness of the metal oxide film was performed by forming a metal oxide film on a silicon wafer instead of the metal material and measuring the thickness using a stylus profilometer (Dektak XT-S, manufactured by Bruker Japan, K.K.).

<Measurement of composition of metal oxide film>

The weights of aluminum atoms, silicon atoms, oxygen atoms, and carbon atoms per unit volume and their ratios were calculated using a dynamic SIMS (PHI ADEPT: manufactured by ULVAC-PHI, Inc.). The conditions for the dynamic SIMS are as follows. The primary ion species was Cs+, the primary acceleration voltage was 5.0 kV, and the detection region was $45 \times 45$ $\mu$m. As the sample, one in which a 1 $\mu$m metal oxide film was formed on a copper substrate was prepared. The measurement was performed at central portion of the sample in the depth direction, and the depth of the point where silicon was detected was defined as 1 $\mu$m. From the secondary ion intensity, relative sensitivity coefficient, and atomic weight of each of aluminum, silicon, oxygen, and carbon atoms, the weight ratio among the four atoms was calculated. Since there was not a difference of 1% or more between the total value of the four atomic weights per unit volume and the specific gravity of the metal oxide film, the weight ratio among the four atoms per unit volume was calculated as the composition ratio assuming that the metal oxide film is mainly composed of the four atoms.

The following evaluation was performed using the multilayers obtained above.

<Examination of amorphous nature>

The amorphous nature of the metal oxide film was measured using an X-ray diffraction (XRD) apparatus (SmartLab, manufactured by Rigaku Corporation). As a sample, a silicon wafer and one in which a 1 $\mu$m metal oxide film was formed on a silicon wafer were prepared, and the measurement was performed under the following conditions. In comparison with the peaks of the silicon wafer, the sample was deemed amorphous in a case where a new diffraction peak did not appear, and the sample was deemed crystalline in a case where a diffraction peak appeared.

Tube voltage: 45 kV
Tube current: 200 mA
X-ray wavelength: Cu-K$\alpha$ ray (1.5418 Å)
Detector: D/teX Ultra 250
Measurement range: $2\theta = \omega$ scan
Scan axis: $2\theta/\theta$
Longitudinal limit slit width: 2.0 mm
Scan mode: CONTINUOUS
Scan speed: 20°/min

<Evaluation of adhesive properties>

Adhesive properties were evaluated by the presence or absence of cracking or peeling off between the metal material and the metal oxide after a thermal cycle test. Specifically, using a TSA-103ES-W thermal cycle testing machine manufactured by ESPEC Co., Ltd., a 30 mm $\times$ 30 mm multilayer was subjected to 200 cycles of thermal cycle test in which one cycle consisted of cooling at -40°C for 35 minutes and heating at 200°C for 35 minutes, and the multilayer was observed under an optical microscope at a magnification of 50-fold. One undergone peeling off and cracking was evaluated as $\times$. Next, the magnification of the optical microscope was increased to 150-fold, observation was performed, and one undergone peeling off was evaluated as $\triangle$ and one not undergone peeling off was evaluated as $\bigcirc$. Furthermore, observation was performed under a scanning microscope (IT-200, manufactured by JEOL Ltd.) at a magnification of 1000-fold, and one not undergone cracking was evaluated as $\circledcirc$.

<Evaluation of insulation properties>

A circular main electrode having a diameter of 10 mm was formed on the metal oxide film of a 30 mm $\times$ 30 mm multilayer using silver paste (DOTITE FA-451a; manufactured by FUJIKURA KASEI CO., LTD.) as a conductive metal multilayer, and a DC voltage of 10 V was applied between the metal material and the main electrode and the current was measured using an insulation meter (SM-7120 Super Megohm Meter, manufactured by HIOKI E.E. CORPORATION), whereby the volume resistivity was measured. One having a volume resistivity of 2,000 G$\Omega\cdot$cm or more was evaluated as $\circledcirc$, one having a volume resistivity of 1,000 G$\Omega\cdot$cm or more and less than 2,000 G$\Omega\cdot$cm was evaluated as O, and one having a volume resistivity of less than 1,000 G$\Omega\cdot$cm was evaluated as $\times$.

<Evaluation of high voltage resistance>

A circular main electrode having a diameter of 10 mm was formed on the metal oxide film of a 30 mm $\times$ 30 mm multilayer using silver paste (DOTITE FA-451a; manufactured by FUJIKURA KASEI CO., LTD.) as a conductive metal multilayer, and a DC voltage was applied between the metal material and the main electrode at a voltage rise rate of 10 V/s and the current was measured using an insulation meter (SM-7120 Super Megohm Meter, manufactured by HIOKI E.E. CORPORATION), and the high voltage resistance was evaluated based on the voltage (dielectric breakdown voltage (V)) when a current of 2 mA or more flowed. A dielectric breakdown voltage of 500 V or more was evaluated as passing.

<Evaluation of heat dissipation properties (thermal conductivity)>

In a dry glove box purged with nitrogen contained in a cylinder, 10 grains of ammonium acetate (melting point: 112°C, manufactured by FUJIFILM Wako Pure Chemical Corporation) that was not deliquesced and had a grain size of 1 mm or less were placed on the metal oxide film of a 30 mm × 30 mm multilayer, and the multilayer was put on a hot plate at 120±3°C with the metal material facing down. An enlarged picture of the manner in which ammonium acetate was melting was taken using a CCD camera, and the time T1 from when the sample was placed on the hot plate until the ammonium acetate completely became liquid was measured. One having a T1 of 120 seconds or less was evaluated as O, one having a T1 of more than 120 seconds and 150 seconds or less was evaluated as △, and one having a T1 of more than 150 seconds was evaluated as ×.

<Evaluation of warpage>

For a sample having a thickness of 0.5 mm, a length of 60 mm, and a width of 5 mm, the short side of the sample is taken as a fixing end and the opposite short side is taken as a free end, and the fixing end is fixed to the measurement table. Thereafter, the distance between the free end and the measurement table was measured using a feeler gauge.
The warpage of the substrate (the proportion of warpage to the length of the sample) was calculated using the following equation.

$$\text{Warpage} = V/60 \times 100 \ (\%)$$

One having a warpage of less than 2% was evaluated as Favorable "O", one having a warpage of 2% or more and 5% or less was evaluated as Acceptable "△", and one having a warpage of more than 5% was evaluated as Unacceptable "×". For example, in a case where V is 4 mm, warpage is 4/60 × 100 (= 6.7)%.

<Examples 2 to 24 and Comparative Examples 2 to 5>

Multilayers were produced by the same operation as in Example 1 except that the conditions for forming the metal oxide film in Example 1 were changed to the conditions presented in Tables 1 to 6, and subjected to the evaluation described above. The results are presented in Tables 1 to 6.

<Comparative Example 1>

A circuit board was obtained with reference to Examples of Patent Document 1. Specifically, a 1.5 mm thick metal material (30 mm × 30 mm) made of copper and a 150 μm thick metal oxide substrate (ceramic substrate 30 mm × 30 mm) made of ZTA (zirconia-reinforced alumina) were bonded together by being heated and pressed using a hot pressing machine. The obtained circuit board was subjected to the evaluation described above. The results are presented in Table 6.

[Table 1]

| Example | | 1 | 2 | 3 | 4 |
|---|---|---|---|---|---|
| Composition of metal material | | Copper | | | |
| Composition of metal material (%) | | Cu = 100 | | | |
| Metal material thickness (mm) | | 0.5 | 1.5 | 5 | 20 |
| Composition of coating liquid (wt%) | Polysilazane | 5 | 5 | 5 | 5 |
| | TEOS | - | - | - | - |
| | Al (acac)3 | 1 | 1 | 1 | 1 |
| | Di-s-butoxyaluminooxytriethoxysilane | - | - | - | - |
| | Acetonitrile | 94 | 94 | 94 | 94 |
| | Toluene | - | - | - | - |

(continued)

| Example | 1 | 2 | 3 | 4 |
|---|---|---|---|---|
| Hot plate temperature (°C) | 250 | 250 | 250 | 250 |
| Composition of metal oxide film (Si/Al/O/C) (weight ratio) | (20.3/29.3/49.2/1.2) | | | |
| Time for film formation (min) | 30 | 30 | 30 | 30 |
| Thickness of metal oxide film ($\mu$m) | 1 | 1 | 1 | 1 |
| Amorphous | Amorphous | Amorphous | Amorphous | Amorphous |
| Adhesive properties | ○ | ○ | ○ | ○ |
| Insulation properties | ⊙ | ⊙ | ⊙ | ⊙ |
| High voltage resistance (dielectric breakdown voltage (V)) | 810 | 850 | 810 | 830 |
| Heat dissipation properties | ⊙ | ⊙ | ⊙ | ⊙ |
| Warpage | ○ | ○ | ○ | ○ |
| Warpage (numerical value: mm) | 0 | 0 | 0 | 0 |

[Table 2]

| Example | | 5 | 6 | 7 | 8 |
|---|---|---|---|---|---|
| Composition of metal material | | Copper | | | |
| Composition of metal material (%) | | Cu = 100 | | | |
| Metal material thickness (mm) | | 1.5 | 1.5 | 1.5 | 1.5 |
| Composition of coating liquid (wt%) | Polysilazane | 0.5 | 1 | 5 | 5 |
| | TEOS | - | - | - | - |
| | Al (acac) 3 | 1.5 | 2 | 0.2 | 0.1 |
| | Di-s-butoxyaluminooxytriethoxysilane | - | - | - | - |
| | Acetonitrile | 98 | 97 | 94.8 | 94.9 |
| | Toluene | - | - | - | - |
| Hot plate temperature (°C) | | 250 | 250 | 250 | 250 |
| Composition of metal oxide film (Si/Al/O/C) (weight ratio) | | (5.4/46.2/47.2 /1.2) | (13.0/37.6/48.2 /1.2) | (32.6/15.4/50.9 /1.1) | (41.5/10.0/47.2 /1.3) |
| Time for film formation (min) | | 30 | 30 | 30 | 30 |
| Thickness of metal oxide film (μm) | | 1 | 1 | 1 | 1 |
| Amorphous | | Amorphous | Amorphous | Amorphous | Amorphous |
| Adhesive properties | | ○ | ⊙ | ⊙ | ○ |
| Insulation properties | | ○ | ⊙ | ⊙ | ○ |
| High voltage resistance (dielectric breakdown voltage (V)) | | 650 | 750 | 820 | 870 |
| Heat dissipation properties | | ⊙ | ⊙ | ⊙ | ⊙ |
| Warpage | | ○ | ○ | ○ | ○ |
| Warpage (numerical value: mm) | | 0 | 0 | 0 | 0 |

[Table 3]

| Example | | | 9 | 10 | 11 | 12 | 13 | 14 | 15 |
|---|---|---|---|---|---|---|---|---|---|
| Composition of metal material | | | Copper | | | | | | |
| Composition of metal material (%) | | | Cu = 100 | | | | | | |
| Metal material thickness (mm) | | | 1.5 | 1.5 | 1.5 | 1.5 | 0.5 | 0.5 | 0.5 |
| Composition of coating liquid (wt%) | Polysilazane | | 1 | 2 | 2 | 5 | - | - | - |
| | TEOS | | - | - | - | - | 0.4 | 1 | - |
| | Al (acac)3 | | 2 | 0.2 | 0.2 | 1 | 1.4 | 0.4 | - |
| | Di-s-butoxyaluminooxytriethoxysilane | | - | - | - | - | - | - | 2 |
| | Acetonitrile | | 97 | 97.8 | 97.8 | 94 | 98.2 | 98.6 | - |
| | Toluene | | - | - | - | - | - | - | 98 |
| Hot plate temperature (°C) | | | 200 | 250 | 180 | 300 | 360 | 400 | 300 |
| Composition of metal oxide film (Si/Al/O/C) (weight ratio) | | | (10.2/39.3 /45.6/4.9) | (18.5/26.7 /53.8/1.0) | (18.8/27.1 /48.1/6.0) | (25.3/24.3 /50.3/0.1) | (3.7/49.5 /45.9/0.9) | (9.9/39.1 /50.2/0.8) | (28.7/19.0 /48.9/3.4) |
| Time for film formation (min) | | | 45 | 20 | 45 | 20 | 30 | 30 | 40 |
| Thickness of metal oxide film (μm) | | | 1 | 1 | 1 | 1 | 1 | 1 | 1 |
| Amorphous | | | Amorphous | Amorphous | Amorphous | Amorphous | Amorphous | Amorphous | Amorphous |
| Adhesive properties | | | ○ | ○ | ○ | ○ | ○ | ○ | ○ |
| Insulation properties | | | ⊙ | ○ | ○ | ⊙ | ⊙ | ⊙ | ⊙ |
| High voltage resistance (dielectric breakdown voltage (V)) | | | 730 | 650 | 620 | 890 | 830 | 900 | 850 |
| Heat dissipation properties | | | ⊙ | ⊙ | ⊙ | ⊙ | ⊙ | ⊙ | ⊙ |
| Warpage | | | ○ | ○ | ○ | ○ | ○ | ○ | ○ |
| Warpage (numerical value: mm) | | | 0 | 0 | 0 | 0 | 0.1 | 0.2 | 0 |

[Table 4]

| Example | | 16 | 17 | 18 | 19 | 20 | 21 |
|---|---|---|---|---|---|---|---|
| Composition of metal material | | Copper | | | | Aluminum | |
| Composition of metal material (%) | | Cu = 100 | | | | Al = 100 | |
| Metal material thickness (mm) | | 1.5 | 1.5 | 1.5 | 1.5 | 0.5 | 0.5 |
| Composition of coating liquid (wt%) | Polysilazane | 5 | 5 | 5 | 5 | 5 | - |
| | TEOS | - | - | - | - | - | 1 |
| | Al (acac) 3 | 1 | 1 | 1 | 1 | 1 | 0.4 |
| | Di-s-butoxyaluminooxytriethoxysilane | - | - | - | - | - | - |
| | Acetonitrile | 94 | 94 | 94 | 94 | 94 | 98.6 |
| | Toluene | - | - | - | - | - | - |
| Hot plate temperature (°C) | | 250 | 250 | 250 | 250 | 250 | 410 |
| Composition of metal oxide film (Si/Al/O/C) (weight ratio) | | | (20.3/29.3/49.2/1.2) | | | | (9.9/39.1 /50.2/0.8) |
| Time for film formation (min) | | 15 | 80 | 400 | 30 | 30 | 25 |
| Thickness of metal oxide film (μm) | | 0.3 | 5 | 25 | 1 | 1 | 1 |
| Amorphous | | Amorphous | Amorphous | Amorphous | Amorphous | Amorphous | Amorphous |
| Adhesive properties | | ○ | ○ | ○ | ○ | ○ | ○ |
| Insulation properties | | ⊙ | ⊙ | ⊙ | ⊙ | ⊙ | ⊙ |
| High voltage resistance (dielectric breakdown voltage (V)) | | 580 | 1600 | 2000 or more | 850 | 850 | 870 |
| Heat dissipation properties | | ⊙ | ⊙ | ○ | ⊙ | ⊙ | ⊙ |
| Warpage | | ○ | ○ | ○ | ○ | ○ | ○ |
| Warpage (numerical value: mm) | | 0 | 0 | 0 | 0 | 0 | 0.25 |

[Table 5]

| Example | | | 22 | 23 | 24 |
|---|---|---|---|---|---|
| Composition of metal material | | | Cu60Mo40 | Al96Mg4 | AlCu5C0.3 |
| Composition of metal material (%) | | | Cu/Mo = 60/40 | Al/Mg = 96/4 | Al/Cu/C = 94.7/5/0.3 |
| Metal material thickness (mm) | | | 1.5 | 1.5 | 1.5 |
| Composition of coating liquid (wt%) | | Polysilazane | 5 | 5 | 5 |
| | | TEOS | - | - | - |
| | | Al (acac) 3 | 1 | 1 | 1 |
| | | Di-s-butoxyaluminooxytriethoxysilane | - | - | - |
| | | Acetonitrile | 94 | 94 | 94 |
| | | Toluene | - | - | - |
| Hot plate temperature (°C) | | | 250 | 250 | 250 |
| Composition of metal oxide film (Si/Al/O/C) (weight ratio) | | | (20.3/29.3/49.2/1.2) | | |
| Time for film formation (min) | | | 30 | 30 | 30 |
| Thickness of metal oxide film (μm) | | | 1 | 1 | 1 |
| Amorphous | | | Amorphous | Amorphous | Amorphous |
| Adhesive properties | | | ○ | ○ | ○ |
| Insulation properties | | | ⊙ | ⊙ | ⊙ |
| High voltage resistance (dielectric breakdown voltage (V)) | | | 870 | 880 | 860 |
| Heat dissipation properties | | | ⊙ | ⊙ | ⊙ |
| Warpage | | | ○ | ○ | ○ |
| Warpage (numerical value: mm) | | | 0 | 0 | 0 |

[Table 6]

| Comparative Example | | 1 | 2 | 3 | 4 | 5 |
|---|---|---|---|---|---|---|
| Composition of metal material | | Aluminum | | | | |
| Composition of metal material (%) | | Al = 100 | | | | |
| Metal material thickness (mm) | | 1.5 | 1.5 | 1.5 | 1.5 | 0.5 |
| Composition of coating liquid (wt%) | Polysilazane | - | - | 5 | 2.5 | - |
| | TEOS | - | - | - | - | 1 |
| | Al (acac)3 | - | 2 | - | 0.5 | 0.4 |
| | Acetonitrile | - | 60 | 95 | 98 | 98.6 |
| | Water | - | 38 | - | - | - |
| Hot plate temperature (°C) | | - | 360 | 250 | 400 | 500 |
| Ceramic | | ZTA | Alumina | Silica | - | - |
| Composition of metal oxide film (Si/Al/O/C) (weight ratio) | | (16.5/41.1/42.4/0) | (0/52.3/46.5/1.2) | 46.0/0/52.8/1.2 | (20.6/29.6/49.8/0) | (9.5/39.5/51.0/0) |
| Time for film formation (min) | | - | 30 | 30 | 30 | 20 |
| Metal oxide film thickness (μm) | | 150 | 1 | 1 | 1 | 1 |
| Film formation method | | Hot pressing | mCVD | mCVD | mCVD | mCVD |

(continued)

| Comparative Example | 1 | 2 | 3 | 4 | 5 |
|---|---|---|---|---|---|
| Amorphous | Crystalline | Amorphous | Amorphous | Amorphous | Amorphous |
| Adhesive properties | × | ⊙ | △ | × | × |
| Insulation properties | ○ | ⊙ | ⊙ | × | × |
| High voltage resistance (dielectric breakdown voltage (V)) | 2000 or more | 450 | 750 | × | × |
| Heat dissipation properties | × | ⊙ | ○ | ⊙ | ⊙ |
| Warpage | ○ | ○ | ○ | ○ | △ |
| Warpage (numerical value: mm) | 0 | 0.15 | 0 | 0.25 | 2.0 |

In Tables 1 to 6, polysilazane denotes ("TRESMILE ANN120-20", manufactured by SANWA KAGAKU CORP.);

Al(acac)3 denotes aluminum tris(acetylacetonate) ("Aluminum Chelate A", manufactured by Kawaken Fine Chemicals Co., Ltd.);
TEOS denotes tetraethyl orthosilicate (TCI); and
Di-s-butoxyaluminoxytriethoxysilane denotes a product manufactured by Thermo Fisher Scientific Inc..

Comparative Example 1 is a metal oxide multilayer produced by a heat pressing method, which is common as a method for producing metal oxide multilayers. The metal oxide multilayer obtained in Comparative Example 1 had a large film thickness and therefore exhibited lower heat dissipation properties than Examples, and the metal oxide multilayer exhibited crystallinity and therefore the metal oxide film peeled off from the metal after the thermal cycle test.
The metal oxide multilayer obtained in Comparative Example 2 exhibited low high voltage resistance since the composition of the metal oxide film was outside the scope of the claims of the present patent.
The metal oxide multilayer obtained in Comparative Example 3 exhibited low adhesive properties and underwent cracking since the composition of the metal oxide film was outside the scope of the claims of the present patent.
In the metal oxide multilayer obtained in Comparative Example 4, peeling off was found in the sample after film formation since the composition of the metal oxide film was outside the scope of the claims of the present patent. Therefore, the adhesive properties, voltage resistance and insulation properties were low.
In the metal oxide multilayer obtained in Comparative Example 5, the sample after film formation underwent warpage and cracking since the temperature for film formation and the composition of the metal oxide film were outside the scope of the claims of the present patent.

**Claims**

1.  An amorphous metal oxide film, wherein
    the metal oxide film is represented by a composition formula: $Si_aAl_bO_cT_d$ (in the formula, Si denotes a silicon atom; Al denotes an aluminum atom; O denotes an oxygen atom; T denotes one atom or a plurality of atoms other than Si, Al, and O; a, b, c, and d denote a weight ratio; a + b + c + d = 100, where a is 3 or more and 45 or less, b is 5 or more and 50 or less, c is 35 or more and 60 or less, and d is 0.05 or more and 10 or less), and has a thickness of 0.1 μm or more and 30 μm or less.

2.  A metal oxide multilayer comprising the metal oxide film according to claim 1 that is directly layered on a sheet-like metal material having a thickness of 0.2 mm or more and 20 mm or less.

3.  The metal oxide multilayer according to claim 2, wherein the metal material is copper or a copper alloy or aluminum or an aluminum alloy.

4.  A method for producing the metal oxide multilayer according to claim 2 or 3, the method comprising:
    a step of conveying mist or droplets obtained by atomizing or converting a coating liquid containing a silicon compound and an aluminum salt or complex with a carrier gas; and a step of reacting the mist or droplets on a metal material in a temperature atmosphere of 150°C or more and 450°C or less to obtain a metal oxide film.

**5.** The method for producing a metal oxide multilayer according to claim 4, wherein the temperature atmosphere is 370°C or less.

FIG. 1

GLASS PIPE

NITROGEN GAS

TEFLON LID

GLASS CYLINDER

COATING LIQUID

WATER

WATER TANK

ULTRASONIC TRANSDUCER

POLYPROPYLENE FILM

OZONE-OXYGEN GAS

IN NITROGEN ATMOSPHERE

METAL MATERIAL

HOT PLATE

## INTERNATIONAL SEARCH REPORT

International application No.

**PCT/JP2024/007502**

| A. | CLASSIFICATION OF SUBJECT MATTER |
|---|---|

*C01B 33/00*(2006.01)i; *C23C 26/00*(2006.01)i; *H01L 23/13*(2006.01)i
FI: C01B33/00; C23C26/00 C; H01L23/12 C

According to International Patent Classification (IPC) or to both national classification and IPC

| B. | FIELDS SEARCHED |
|---|---|

Minimum documentation searched (classification system followed by classification symbols)

C01B33/00; C23C26/00; H01L23/00; H01L21/00; H01L29/00; B32B9/00

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

CAplus/REGISTRY (STN)

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | BIK, M. et al., Optimization of the formation of coatings based on SiAlOC glasses via structural, microstructural and electrochemical studies. Electrochimica Acta. 2019, 309, 44-56 in particular, 2. Experimental, 3. Results and discussion, fig. 1, 2, 3 | 1-2 |
| A | | 3-5 |
| Y | XU, Tianheng et al. High-temperature behavior of Al-doped polymer-derived SiAlOC glasses in air environment. Ceramics International. 2014, 40, 13787-13792 in particular, 1. Introduction , table 1 | 1-2 |
| A | | 3-5 |
| P, A | WO 2023/176770 A1 (NOF CORPORATON) 21 September 2023 (2023-09-21) entire text | 1-5 |
| P, A | WO 2023/032748 A1 (NOF CORPORATON) 09 March 2023 (2023-03-09) entire text | 1-5 |

☑ Further documents are listed in the continuation of Box C.　　☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **19 April 2024** | **14 May 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (July 2022)

**INTERNATIONAL SEARCH REPORT**

| International application No. |
| --- |
| **PCT/JP2024/007502** |

### C. DOCUMENTS CONSIDERED TO BE RELEVANT

| Category* | Citation of document, with indication, where appropriate, of the relevant passages | Relevant to claim No. |
| --- | --- | --- |
| P, A | BIK, M. et al. Oxidation behaviour of uncoated and PDC-SiAlOC glass-coated TiAl at 750 ℃ in dry and humid air. Applied Surface Science. 27 May 2023, 632, 157601, 1-12<br>entire text | 1-5 |

Form PCT/ISA/210 (second sheet) (July 2022)

## INTERNATIONAL SEARCH REPORT
### Information on patent family members

International application No.

**PCT/JP2024/007502**

| Patent document cited in search report | Publication date (day/month/year) | Patent family member(s) | Publication date (day/month/year) |
|---|---|---|---|
| WO 2023/176770 A1 | 21 September 2023 | (Family: none) | |
| WO 2023/032748 A1 | 09 March 2023 | CN 117321755 A | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 8195450 A
- JP 2018140352 A
- JP 2018172793 A

**Non-patent literature cited in the description**

- *Journal of the Society of Materials Science*, 2013, vol. 62 (11), 663-667
- *Journal of Electric Engineering C*, 2007, vol. 127 (11), 1822-1825